# EUROPEAN PATENT APPLICATION

(11) **EP 4 369 409 A1**
(43) Date of publication of application: **15.05.2024**
(21) Application number: 23208113.3
(22) Date of filing: 07.11.2023
(51) Int. Cl.: H01L 29/24, H01L 29/739, H01L 29/78, H01L 29/786, H10B 51/30, H01L 29/49, H01L 21/28, H01L 29/51

(54) **JUNCTION STRUCTURE ELEMENT, METHOD OF MANUFACTURING THE SAME, AND IN-MEMORY COMPUTING DEVICE INCLUDING THE SAME**

(30) Priority: 08.11.2022 KR 20220147572
(71) Applicant: Research & Business Foundation Sungkyunkwan University, Gyeonggi-do 16419 (KR)
(72) Inventor: LEE, Sung Joo, 13832 Gwacheon-si, Gyeonggi-do (KR); BAEK, Sung Pyo, 16324 Suwon-si, Gyeonggi-do (KR); YOO, Hyun Ho, 16360 Suwon-si, Gyeonggi-do (KR); JEON, Su Min, 16421 Suwon-si, Gyeonggi-do (KR); NIU, Jingle, 16417 Suwon-si, Gyeonggi-do (KR)
(74) Representative: BCKIP Part mbB

(57) **Abstract**

A junction structure element (100), a method of manufacturing the same, and an in-memory computing device including the same are disclosed. The junction structure element may include: a first polarization layer (101) containing a material having a ferroelectric characteristic of being polarized only horizontally; a second polarization layer (102) disposed on the first polarization layer and containing a material having a ferroelectric characteristic of being polarized only vertically; a source electrode (104) and a drain electrode (105) each in contact with the first polarization layer (101) and spaced apart from each other; and a gate electrode (106) disposed on the second polarization layer (102).

## Description

### CROSS-REFERENCE TO RELATED APPLICATIONS

The present application claims the benefit of Korean Patent Application No.10-2022-0147572 filed in the Korean Intellectual Property Office on November 08, 2022.

### BACKGROUND

### Field

The present invention relates to a junction structure element, a method of manufacturing the same, and an in-memory computing device including the same.

### Description of the Related Art

An Si-based integrated circuit based on Moore's Law has reached the scaling limit in the size of the device itself and also has a limit in data processing speed due to the Neumann bottleneck phenomenon resulting from the physical form of separating a data processing circuit and a storage device. A two-dimensional materialbased device has a van der Waals (vdW) layered structure of an ultrathin type and a flat surface without defects, and may overcome the scaling limit through a characteristic of being used as a semiconductor, a conductor, or an insulator. In addition, as an in-memory computing device (data processing within a memory device) is implemented, the limit in the data processing can be overcome.

Although ferroelectric field-effect transistors (FeFETs) are studied as one of devices capable of implementing an in-memory computing device, as FeFETs implemented based on existing ferroelectric materials (oxide and perovskite) have limitations of materials, such as low-quality interface, CMOS incompatibility, charge trap, gate leakage, and the like, they have difficulties in utilization. In addition, there is also a problem of instability in the operation of the devices. Existing multi-state ferroelectric memory devices (multi-bit FeFETs) implement multiple memory states by implementing an intermediate state in which positive and negative polarizations are mixed between two types (positive and negative) of saturated polarizations. Such an intermediate state is implemented by adjusting the size and width of electric pulse input, and as the same polarization state may not be implemented for each operation due to the nature of the intermediate state in which polarizations are mixed, there is a principal limitation of non-uniformity in the operational characteristics.

A two-dimensional ferroelectric material (CIPS based on OOP polarization control, 1T-WTe₂, SnS based on IP polarization control, SnTe, SnSe, GeS, β'-In₂Se₃, BA₂PbCl₄, or α-In₂Se₃ based on IP-OOP interrelated polarization control) is a material that can overcome the limitations of materials (low-quality interface, charge trap, and gate leakage) of existing ferroelectric materials as it has a crystalline structure and a dangling bond-free vdW surface. However, as the FeFET device structures are the same (a single ferroelectric material is used as a channel) although the constituent materials are different, it has principal limitations (characteristic of non-uniform operation resulting from polarization intermediate utilization) from the aspect of implementing multiple memories, like ferroelectric oxide or perovskite.

### SUMMARY

Therefore, the present invention has been made in view of the above problems, and it is an object of the present invention to provide a junction structure element independently having polarization control characteristics of different directions.

Another object of the present invention is to provide a method of manufacturing the junction structure element.

Another object of the present invention is to provide an in-memory computing device including the junction structure element.

To accomplish the above objects, according to one aspect of the present invention, there is provided a junction structure element comprising: a first polarization layer containing a material having a ferroelectric characteristic of being polarized only horizontally; a second polarization layer disposed on the first polarization layer and containing a material having a ferroelectric characteristic of being polarized only vertically; a source electrode and a drain electrode each in contact with the first polarization layer and spaced apart from each other; and a gate electrode disposed on the second polarization layer.

In an embodiment, the junction structure element may further comprise an insulating layer disposed between the first polarization layer and the second polarization layer and containing a material having non-dielectric and insulating characteristics.

In an embodiment, thickness of the insulating layer may be 5 to 15nm.

In an embodiment, the insulating layer may contain h-BN.

In an embodiment, the first polarization layer and the second polarization layer may contain one or more materials independently and differently selected from a group including CuInP₂S₆ (CIPS) and SnS.

In an embodiment, the first polarization layer may contain SnS.

In an embodiment, the second polarization layer may contain CIPS.

In an embodiment, when a voltage equal to or higher than a predetermined first threshold voltage is applied between the source electrode and the drain electrode, the first polarization layer may be polarized in a horizontal direction, or a polarization state may be released, and when a voltage is applied to the gate electrode, the second polarization layer may be polarized in a vertical direction, or the polarization state may be released, and whether the first polarization layer is polarized and whether the second polarization layer is polarized independently may determine electrical conductivity of the first polarization layer.

In an embodiment, when the first polarization layer and the second polarization layer are polarized in the horizontal and vertical directions, respectively, the polarization layers may be polarized to be saturated.

In an embodiment, the junction structure element may have a first resistance state; a fourth resistance state having an electrical conductivity higher than that of the first resistance state; a second resistance state having an electrical conductivity between the first resistance state and the fourth resistance state; and a third resistance state having an electrical conductivity between the second resistance state and the fourth resistance state.

In an embodiment, the first resistance state may be implemented by applying a positive voltage between the source electrode and the drain electrode and a negative voltage to the gate electrode.

In an embodiment, the second resistance state may be implemented by applying a negative voltage between the source electrode and the drain electrode and a negative voltage to the gate electrode.

In an embodiment, the third resistance state may be implemented by applying a positive voltage between the source electrode and the drain electrode and a positive voltage to the gate electrode.

In an embodiment, the fourth resistance state may be implemented by applying a negative voltage between the source electrode and the drain electrode and a positive voltage to the gate electrode.

In an embodiment, thickness of the first polarization layer may be 5 to 15nm.

In an embodiment, thickness of the second polarization layer may be 60 to 100nm.

In an embodiment, each of the source electrode and the drain electrode may contain one or more materials selected from a group including titanium (Ti) and gold (Au).

In an embodiment, the gate electrode may contain Si/SiO₂.

In another aspect, there is provided a junction structure element comprising: a first polarization layer containing a material having a ferroelectric characteristic of being polarized only horizontally; a second polarization layer disposed on the first polarization layer 101 and containing a material having a ferroelectric characteristic of being polarized only vertically; a source electrode and a drain electrode each in contact with the first polarization layer and spaced apart from each other; and a gate electrode disposed on the second polarization layer, wherein as each of the first polarization layer and the second polarization layer may independently have polarization directions of two states including a direction from an anode to a cathode or a direction from the cathode to the anode, there may be a total of four states.

In another aspect, there is provided a method of manufacturing a junction structure element comprising: a first step of forming, using a physical peeling method, a first thin film containing a ferroelectric material having a horizontal polarization characteristic, a second thin film containing a ferroelectric material having a vertical polarization characteristic, and an insulating thin film having an insulating characteristic; and a second step of forming the insulating thin film between the first thin film and the second thin film, forming source and drain electrodes respectively in contact with the first thin film and spaced apart from each other, and forming a gate electrode in contact with the second thin film.

In an embodiment, the second step may be performed by sequentially transferring the second thin film, the insulating thin film, and the first thin film on a substrate containing Si/SiO₂.

In an embodiment, the gate electrode may be implemented by the substrate.

In an embodiment, the first thin film and the second thin film may be formed as a thin film containing one or more materials independently and differently selected from a group including CuInP₂S₆ (CIPS) and SnS.

In an embodiment, the first thin film may be formed to contain SnS.

In an embodiment, the second thin film may be formed to contain CIPS.

In an embodiment, the insulating thin film may be formed to contain h-BN.

In an embodiment, the first thin film may be formed to have a thickness of about 5 to 15nm.

In an embodiment, the second thin film may be formed to have a thickness of about 60 to 100nm.

In an embodiment, the insulating layer may be formed to have a thickness of about 5 to 15nm.

In another aspect, there is provided an in-memory-computing device comprising a junction structure element.

In an embodiment, the junction structure element may have a first resistance state; a fourth resistance state having an electrical conductivity higher than that of the first resistance state; a second resistance state having an electrical conductivity between the first resistance state and the fourth resistance state; and a third resistance state having an electrical conductivity between the second resistance state and the fourth resistance state.

In an embodiment, direct transition between the first to fourth resistance states may be possible.

In an embodiment, the in-memory-computing device may have functional completeness.

### BRIEF DESCRIPTION OF THE DRAWINGS

FIG. 1 is a side view schematically showing a junction structure element according to an embodiment of the present invention.
FIG. 2 is a flowchart illustrating a method of manufacturing a junction structure element according to an embodiment of the present invention.
FIGS. 3 to 42 are views showing results according to embodiments and experimental examples of the present invention.

### DETAILED DESCRIPTION OF THE PREFERRED EMBODIMENT

Hereinafter, embodiments of the present invention will be described in detail with reference to the attached drawings. Since the present invention may make various changes and have various forms, specific embodiments will be illustrated in the drawings and described in detail in the detailed description. However, this is not intended to limit the present invention to specific disclosure forms, and should be understood to include all modifications, equivalents, and substitutes included in the spirit and technical scope of the present invention. Like reference numerals are used for like elements throughout the description of the drawings. In the attached drawings, the dimensions of the structures are enlarged to be larger than the actual size for clarity of the present invention.

Terms used in this application are used only to describe specific embodiments, and are not intended to limit the present invention. Singular expressions include plural expressions unless the context clearly dictates otherwise. It should be understood that in this application, terms such as "include", "have", and the like are intended to specify presence of a feature, number, step, operation, component, or a combination thereof described in the specification, and do not preclude the possibility of presence or addition of one or more other features, numbers, steps, operations, components, or combinations thereof.

Unless otherwise defined, all terms used herein, including technical or scientific terms, have the same meaning as commonly understood by those skilled in the art. Terms such as those defined in a commonly used dictionary should be interpreted as having a meaning consistent with the meaning in the context of the related art, and are not construed in an ideal or excessively formal sense unless explicitly defined in this application.

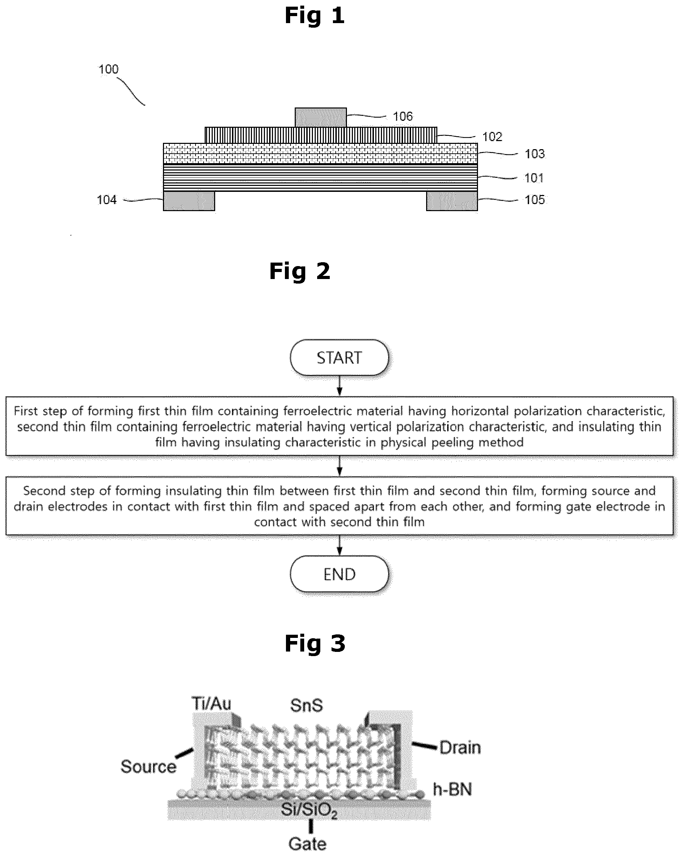

FIG. 1 is a side view schematically showing a junction structure element according to an embodiment of the present invention.

Referring to FIG. 1, the junction structure element 100 according to an embodiment of the present invention may include a first polarization layer 101 containing a material having a ferroelectric characteristic of being polarized only horizontally; a second polarization layer 102 disposed on the first polarization layer 101 and containing a material having a ferroelectric characteristic of being polarized only vertically; a source electrode 104 and a drain electrode 105 each in contact with the first polarization layer 101 and spaced apart from each other; and a gate electrode 106 disposed on the second polarization layer 102.

The first polarization layer 101 may contain a material having ferroelectric characteristics. In the context of this specification, "polarization" means a phenomenon in which the positions of negative and positive charges are separated to have a dipole moment in an electric field. In the context of this specification, ferroelectricity means a property of having a positive and/or negative polarity due to an external electric field and maintaining the state even when the external electric field is removed. The first polarization layer 101 may be polarized only in the horizontal direction. In an embodiment, the first polarization layer 101 may have a structure that allows polarization only in the horizontal direction on a thin film.

The second polarization layer 102 may contain a material having ferroelectric characteristics. The second polarization layer 102 may be polarized only in the vertical direction. In an embodiment, the second polarization layer 102 may have a structure that allows polarization only in the vertical direction on a thin film.

As long as the functions as described above are performed, the materials contained in the first polarization layer 101 and the second polarization layer 102 are not particularly limited. In an embodiment, the first polarization layer 101 and the second polarization layer 102 may contain one or more materials independently and differently selected from a group including CuInP₂S₆ (CIPS) and SnS. In an embodiment, the first polarization layer 101 may contain SnS. In an embodiment, the second polarization layer 102 may contain CIPS.

As long as the functions as described above are performed, the structures of the first polarization layer 101 and the second polarization layer 102 are not particularly limited. In an embodiment, thickness of the first polarization layer 101 may be about 5 to 15nm. In an embodiment, thickness of the second polarization layer 102 may be about 60 to 100nm.

The source electrode 104 and the drain electrode 105 are electrodes in contact with the first polarization layer 101. Since the source electrode 104 and the drain electrode 105 are electrodes, they may contain a conductive material. The source electrode 104 and the drain electrode 105 may be spaced apart from each other. The source electrode 104 and the drain electrode 105 are electrodes spaced apart from each other, and may form an input and an output of a conductive path by way of a conductive path formed on the first polarization layer 101.

The gate electrode 106 is an electrode that applies voltage to the second polarization layer 102. Since the gate electrode 106 is an electrode, it may contain a conductive material. The gate electrode 106 may adjust the polarization state by applying a voltage to the second polarization layer 102.

As long as the source electrode 104, the drain electrode 105, and the gate electrode 106 perform the functions described above, the materials and structures are not particularly limited. In an embodiment, each of the source electrode 104 and the drain electrode 105 may contain one or more materials selected from a group including titanium (Ti) and gold (Au). In an embodiment, the gate electrode 106 may contain Si/SiO₂. In an embodiment, the gate electrode 106 may be implemented as a substrate containing Si/SiO₂ when the second polarization layer 102 or the like is formed on the substrate.

In an embodiment, the junction structure element 100 may further include an insulating layer 103 disposed between the first polarization layer 101 and the second polarization layer 102 and containing a material having non-dielectric and insulating characteristics.

The insulating layer 103 may contain a material having insulating characteristics. In the context of this specification, "insulation" means a property of blocking conduction without providing a conductive path having significant conductivity. As long as the functions as described above are performed, the materials and structures included in the insulating layer 103 are not particularly limited. In an embodiment, the insulating layer 103 may contain h-BN. In an embodiment, thickness of the insulating layer 103 may be about 5 to 15nm.

In conclusion, in the junction structure element 100 according to an embodiment of the present invention, when a voltage is applied between the source electrode 104 and the drain electrode 105, the polarization state of the first polarization layer 101 changes, and electrical conduction may occur through the first polarization layer 101. In an embodiment, according to the polarization state of the first polarization layer 101 that changes by the voltage applied between the source electrode 104 and the drain electrode 105, the behavior of electrical conduction through the first polarization layer 101 may change. In addition, when a voltage is applied to the gate electrode 106, the polarization state of the second polarization layer 102 may change. In an embodiment, the polarization state of the second polarization layer 102 may affect the polarization state or electrical conduction behavior of the first polarization layer 101. In an embodiment, when a voltage equal to or higher than a predetermined first threshold voltage is applied between the source electrode 104 and the drain electrode 105, the first polarization layer 101 is polarized in the horizontal direction, or the polarization state is released, and when a voltage is applied to the gate electrode 106, the second polarization layer 102 is polarized in the vertical direction, or the polarization state is released, and whether the first polarization layer 101 is polarized and whether the second polarization layer 102 is polarized may independently determine electrical conductivity of the first polarization layer 101.

When the first polarization layer 101 and the second polarization layer 102 are polarized by the voltage applied to the source electrode 104, the drain electrode 105, and the gate electrode 106 as described above, the polarization may be saturated polarization or unsaturated polarization. In an embodiment, when the first polarization layer 101 and the second polarization layer 102 are polarized in the horizontal and vertical directions, respectively, the polarization layers may be polarized to be saturated.

When the junction structure element 100 according to an embodiment of the present invention having such a structure and exhibiting a behavior as described above is polarized to be saturated, the first polarization layer 101 and the second polarization layer 102 may have two states, respectively. That is, they may have two states including a state in which saturated polarization occurs in a first direction and a state in which saturated polarization occurs in a second direction opposite to the first direction. Here, the direction of polarization may be from the anode to the cathode, or from the cathode to the anode. When the first polarization layer 101 and the second polarization layer 102 have two states respectively as described above, and these states exist independently, the junction structure element 100 may have at least four states in total. For example, the junction structure element 100 may have four states.

In an embodiment, the junction structure element 100 may have a first resistance state; a fourth resistance state having an electrical conductivity higher than that of the first resistance state; a second resistance state having an electrical conductivity between the first resistance state and the fourth resistance state; and a third resistance state having an electrical conductivity between the second resistance state and the fourth resistance state. In the context of this specification, "resistance state" means a state determined by parameters related to electrical conduction. In an embodiment, the first resistance state may be implemented by applying a positive voltage between the source electrode 104 and the drain electrode 105 and a negative voltage to the gate electrode 106. In an embodiment, the second resistance state may be implemented by applying a negative voltage between the source electrode 104 and the drain electrode 105 and a negative voltage to the gate electrode 106. In an embodiment, the third resistance state may be implemented by applying a positive voltage between the source electrode 104 and the drain electrode 105 and a positive voltage to the gate electrode 106. In an embodiment, the fourth resistance state may be implemented by applying a negative voltage between the source electrode 104 and the drain electrode 105 and a positive voltage to the gate electrode 106. In the context of this specification, "positive voltage" is a voltage of positive polarity, which means that the direction of the positive voltage coincides with the direction from the cathode of polarization to the anode of polarization. In the context of this specification, "negative voltage" is a voltage of negative polarity, which means that the direction of the negative voltage coincides with the direction from the anode of polarization to the cathode of polarization.

Since the junction structure element according to an embodiment of the present invention may independently control polarization in different directions on the first polarization layer and the second polarization layer, and a 2-bit memory may be implemented through this, and polarization may be controlled independently, it does not go through an intermediate state of each state.

As discussed above, the junction structure element according to an embodiment of the present invention has a characteristic of independently controlling polarization in different directions, and may implement a 2-bit memory.

FIG. 2 is a flowchart illustrating a method of manufacturing a junction structure element according to an embodiment of the present invention.

Referring to FIG. 2, the method 200 of manufacturing a junction structure element according to an embodiment of the present invention may include a first step (S210) of forming, using a physical peeling method, a first thin film containing a ferroelectric material having a horizontal polarization characteristic, a second thin film containing a ferroelectric material having a vertical polarization characteristic, and an insulating thin film having an insulating characteristic; and a second step (S220) of forming the insulating thin film between the first thin film and the second thin film, forming source and drain electrodes respectively in contact with the first thin film and spaced apart from each other, and forming a gate electrode in contact with the second thin film.

The first step (S210) is a step of forming the first thin film, the second thin film, and the insulating thin film using a physical peeling method. Description of the method 200 of manufacturing a junction structure element according to an embodiment of the present invention may be applied to the same or similar configuration in the same or similar manner in the description of the junction structure element according to an embodiment of the present invention described above. Particularly, the first thin film, the second thin film, and the insulating thin film may be applied in a manner the same as or similar to the description of the first polarization layer, the second polarization layer, and the insulating layer in the description of the junction structure element according to an embodiment of the present invention described above.

Therefore, the first thin film may have characteristics of ferroelectricity and horizontal polarization similar to those of the first polarization layer, and the second thin film may have characteristics of ferroelectricity and vertical polarization similar to those of the second polarization layer, and the insulating thin film may have non-dielectric and insulating characteristics similar to those of the insulating layer. Accordingly, in an embodiment, the first thin film and the second thin film may be formed as a thin film containing one or more materials independently and differently selected from a group including CuInP₂S₆ (CIPS) and SnS. In addition, in an embodiment, the first thin film may be formed to contain SnS. In addition, in an embodiment, the second thin film may be formed to contain CIPS. In addition, in an embodiment, the insulating thin film may be formed to contain h-BN.

In the context of this specification, the "physical peeling method" is a physical (mechanical) method, which means a method of manufacturing a thin film in a method of peeling off the thin film.

The first thin film may perform the same function as the first polarization layer, the second thin film may perform the same function as the second polarization layer, and the insulating thin film may perform the same function as the insulating layer. As long as the functions as described above are performed, the materials and functions of the first thin film, the second thin film, and the insulating thin film are not particularly limited. In an embodiment, the first thin film may be formed to have a thickness of about 5 to 15nm. In an embodiment, the second thin film may be formed to have a thickness of about 60 to 100nm. In an embodiment, the insulating layer may be formed to have a thickness of about 5 to 15nm.

The second step (S220) is a step of forming a source electrode, a drain electrode, and a gate electrode. As described above, description of the method 200 of manufacturing a junction structure element according to an embodiment of the present invention may be applied to the same or similar configuration in the same or similar manner in the description of the junction structure element according to an embodiment of the present invention described above. Therefore, in an embodiment, the gate electrode may be implemented by a substrate containing Si/SiO₂. In addition, in an embodiment, the second step (S220) may be performed by sequentially transferring the second thin film, the insulating thin film, and the first thin film on a substrate containing Si/SiO₂.

An in-memory computing device according to an embodiment of the present invention may include the junction structure element described above.

Description of the in-memory computing device according to an embodiment of the present invention may be applied to the same or similar configuration in the same or similar manner in the description of the junction structure element and a manufacturing method thereof according to an embodiment of the present invention described above.

In an embodiment, the junction structure element 100 may have a first resistance state; a fourth resistance state having an electrical conductivity higher than that of the first resistance state; a second resistance state having an electrical conductivity between the first resistance state and the fourth resistance state; and a third resistance state having an electrical conductivity between the second resistance state and the fourth resistance state. In an embodiment, direct transition between the first to fourth resistance states may be possible. In the context of this specification, "direct transition" between any states means a property of immediate transition without an intermediate state between two states. In addition, in an embodiment, the in-memory computing device may have functional completeness. In the context of this specification, "functional completeness" may mean that when the in-memory computing device is used in a set, a group similar to a set, or a member containing such a set or group as a property, it can be used to express all possible truth tables by combining the configuration with Boolean expressions.

Hereinafter, embodiments of the present invention will be described in detail. However, the embodiments described below are only some of the embodiments of the present invention, and the scope of the present invention is not limited to the following embodiments.

### Fabrication of device through acquisition and stacking of CIPS, h-BN, and SnS nano thin films

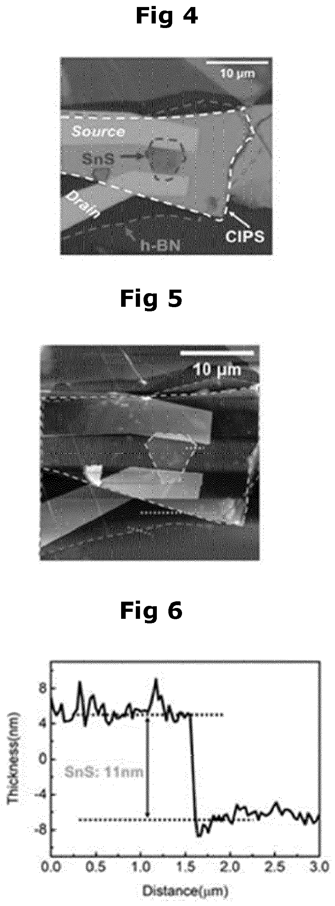

Multiple thin film layers of CIPS, h-BN, and SnS are secured through the physical peeling method. The secured thin films are sequentially transferred onto an SiO₂/Si substrate through a dry transfer method to form a stacked structure of a CIPS/h-BN/SnS form. Thereafter, source and drain electrodes are deposited at a thickness of Ti(10nm)/Au(80nm). At this point, the source and drain electrodes are formed on the SnS channel. The structure of the completed Dualferroelectric FET (D-FeFET, a junction structure element of a ferroelectric material capable of controlling horizontal polarization and a ferroelectric material capable of controlling vertical polarization) is as shown in FIGS. 3 to 8. FIG. 3 is a structural mimetic view showing a two-dimensional heterojunction D-FeFET of CIPS/h-BN/SnS. FIG. 4 shows an optical microscopy (OM) image of an implemented device. FIGS. 5 to 8 show an atomic force microscopy (AFM) image (FIG. 5) of the thickness of CIPS, h-BN, and SnS constituting a junction structure, and a result of measuring the height profile extracted therefrom (FIGS. 6, 7, and 8). The thicknesses of SnS, CIPS, and h-BN are measured along the dotted lines, respectively, and thicknesses of 11nm, 75nm, and 10nm are confirmed as a result of the measurement.

### <Raman and PFM measurement>

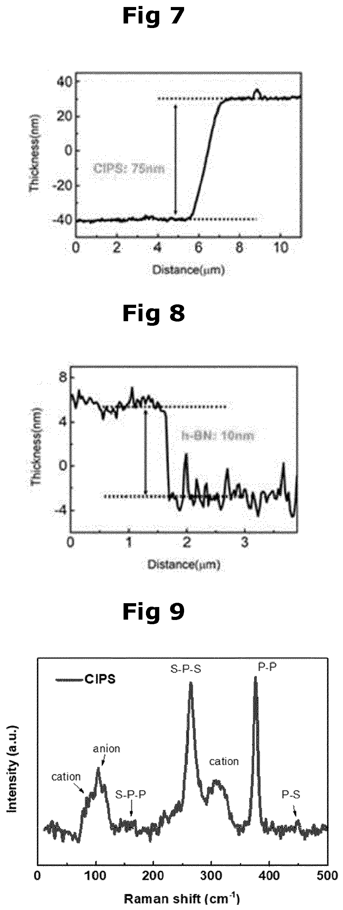

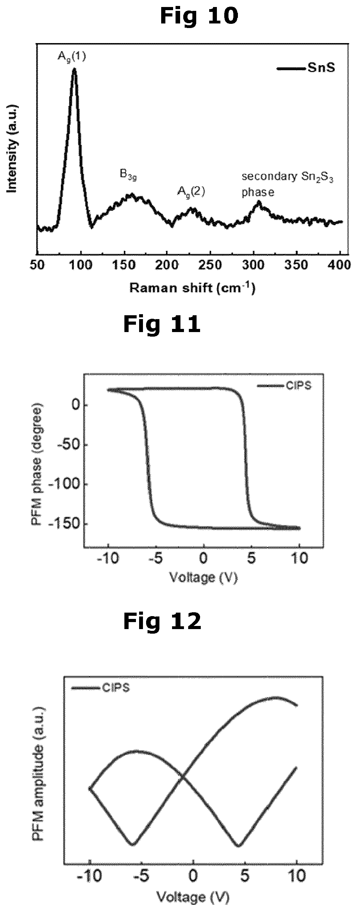

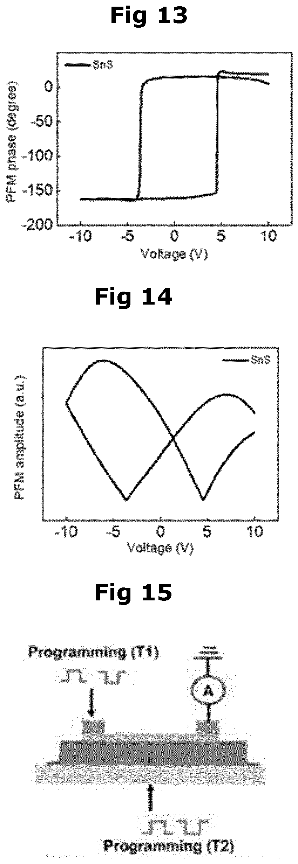

FIGS. 9 to 14 show Raman spectra of a ferroelectric material and measurement results of Piezoresponse Force Microscopy (PFM). FIGS. 9 and 10 show Raman spectra of CIPS (FIG. 9) and SnS (FIG. 10) physically peeled off at room temperature, respectively. The measured Raman results are consistent with previously reported measurement results of CIPS and SnS having ferroelectric characteristics. In the case of CIPS, Raman peaks observed at 100cm⁻¹ and 316cm⁻¹ originate from vibration of anion (P²Se⁴⁻) and cation (Cu^{I}, In^{III}), respectively. The picks observed at 138cm⁻¹ and 163cm⁻¹ mean a δ(S-P-P) mode, the pick observed at 265cm⁻¹ means a δ(S-P-S) mode, the pick observed at 375.8cm⁻¹ means a v(P-P) mode, and the pick observed at 450cm⁻¹ means a v(P-S) mode. In the case of SnS, the picks observed at 98cm⁻¹ and 224cm⁻¹ mean an Ag mode of SnS. The pick observed at 302cm⁻¹ is associated with a secondary Sn₂S₃ phase, and the pick observed at 161.7cm⁻¹ means a B_{3g} mode. FIGS. 11 to 14 show measurement results of piezoresponse force measurement (PFM) performed to measure the OOP ferroelectricity of CIPS and the IP ferroelectricity of SnS at room temperature. In a single point PFM measurement method, OOP mode (FIGS. 11 and 12) measurement is performed on CIPS flakes, and IP mode (FIGS. 13 and 14) measurement is performed on SnS flakes. A voltage in a range of -8V to 8V is applied to the AFM tip to perform a PFM phase measurement according to the voltage. OOP ferroelectricity of the CIPS flakes and IP ferroelectricity of the SnS flakes are confirmed through a clear hysteresis loop, 180° shift of the PFM phase, and a well-defined butterfly curve measured at the PFM amplitude.

### <Characteristics of 2bit non-volatile memory device of 2D D-FeFET>

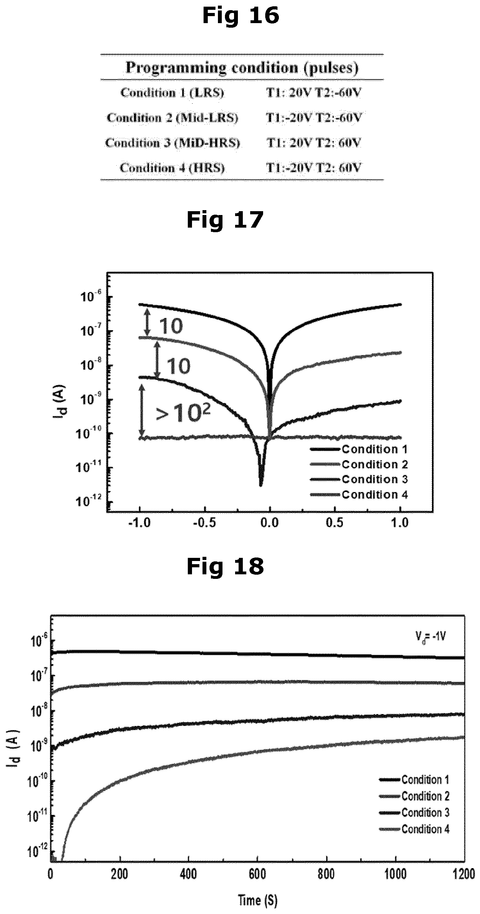

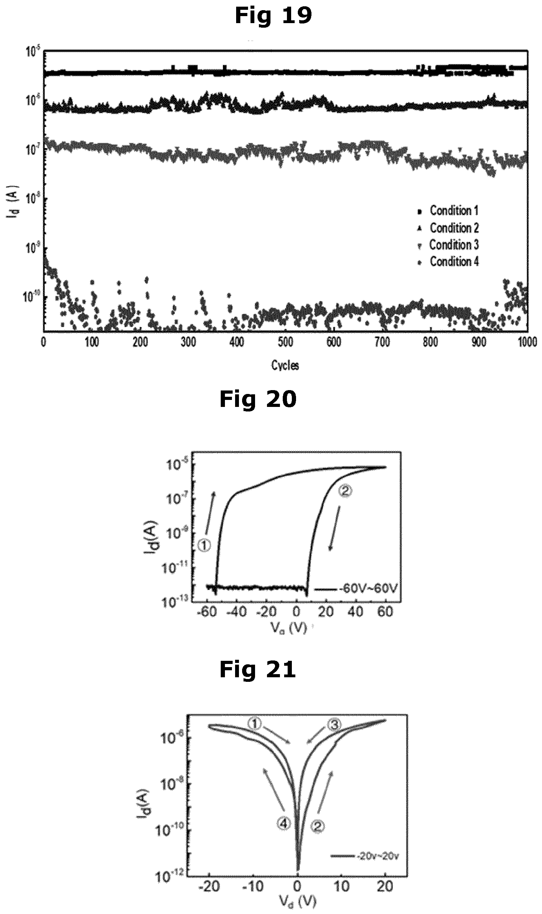

FIGS. 15 to 19 show 2-bit volatile memory characteristics implemented by controlling the vertical (hereinafter, referred to as out-of-plane OOP) polarization direction of CIPS and the horizontal (hereinafter, referred to as in-plane IP) polarization direction of SnS in a 2D D-FeFET structure. FIG. 15 is a mimetic view showing programming of a D-FeFET. Two programming voltage pulses are simultaneously applied to the drain T1 and gate T2 terminals to control the IP and OOP polarization directions, respectively. At this point, the source terminal is grounded. The memory storage state is read as channel current while a low drain voltage is applied after the programming voltage is turned off. FIG. 16 shows the programming voltage pulse conditions of T1 and T2 set to implement each storage state. FIG. 17 shows the drain current level of each storage state implemented after the voltage pulse set in FIG. 16 is applied. At this point, the drain voltage range during the measurement is -1V to 1V, and as it is much lower than the coercive voltage of SnS (the minimum voltage needed to change the polarization direction of the ferroelectric material), the direction of polarization does not change during the measurement. Read current is clearly divided into four levels according to the four programming conditions that are set. Hereinafter, the storage states will be indicated as Low Resistance State (LRS, condition 1), Mid-LRS (condition 2), Mid-HRS (condition 3), and High Resistance State (HRS, condition 4) according to the current/resistance level. The resistance difference in each storage state is I_{LRS}/I_{Mid-LRS}=∼10, I_{Mid-LRS}/I_{Mid-HRS}=∼10, and I_{Mid-HRS}/I_{HR3}=∼10². FIG. 18 shows retention characteristics of the D-FeFET, showing that the four resistance states are maintained to be more than 10³s while maintaining the difference of being distinguished from each other. FIG. 19 shows endurance characteristics of the D-FeFET, showing that each resistance state is stably implemented without dispersion even in an operation over 10³ cycles.

### <Operation principle of 2D 2bit D-FeFET>

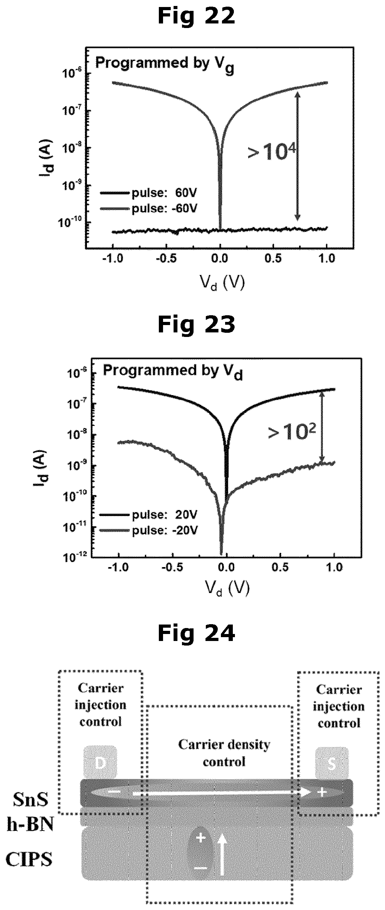

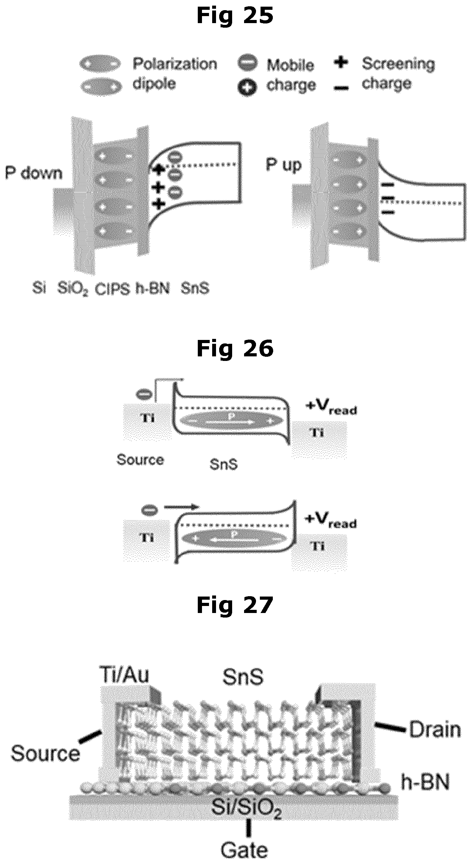

FIG. 20 shows the transfer curve of the 2D D-FeFET. The gate voltage Vg is measured by sweeping from -60V to 60V and then again to -60V, and at this point, the drain voltage V_{d} is maintained at 1V. (V_{d} of 1V applied to the source and drain terminals is a very small value compared to the IP programming voltage, and it is a state that does not induce a polarization alignment phenomenon in SnS. That is, it is a state that may confirm only the OOP polarization control characteristics by Vg.) A clockwise hysteresis loop having a wide hysteresis window (85V) and a high on/off ratio (10⁵) appears, and this is a characteristic similar to that of the previously reported 2D FeFET. Here, the hysteresis induced by the gate voltage is a characteristic that appears by controlling the OOP polarization direction of CIPS. In a structure without CIPS, wide hysteresis does not appear in the transfer curve as shown in FIGS. 27 to 30, and this is since the ferroelectric dipole of SnS responds only to IP electric fields and does not respond to OOP electric fields. Therefore, when there is no CIPS, a sufficiently wide hysteresis cannot be secured using only the gate voltage. FIG. 25 shows a band diagram when only the effect of Vg is considered. When a positive gate voltage is applied to the gate terminal, the polarization direction of CIPS is aligned to the upward state. Negative charges are injected into the channel and bounded to the SnS/h-BN interface. The bounded negative charges have an effect of screening positive polarization charges of CIPS. Electrons in the SnS channel are depleted (carrier density decreases) due to the electrostatic field generated due to the bounded negative charges. On the contrary, when a negative gate voltage is applied, an electron accumulation phenomenon occurs in the SnS channel (carrier density increases) due to positive screening charges generated at the SnS/h-BN interface. FIG. 21 shows the output curve of the 2D D-FeFET. It shows that IP polarization and channel current can be controlled only with V_{d} due to the IP ferroelectricity of the SnS channel. V_{d} is measured by sweeping from -20V to 20V and then again to -20V, and at this point, no voltage is applied to V_{g} (The polarization alignment phenomenon has not been induced in CIPS. That is, only the IP polarization control characteristics by V_{d} can be confirmed.) It can be confirmed that a hysteresis loop having an on/off ratio of about 10² appears. When V_{d} is equal to or smaller than ±10V, clear hysteresis is not observed, and this is due to the coercive field of SnS (~10.7kV/cm) and the channel length (8µm). FIG. 26 shows a band diagram when only the effect of V_{d} is considered. After SnS and Ti are bonded, an upward bend bending phenomenon occurs in SnS due to the band alignment at the SnS/Ti interface. At this point, the device may be viewed as being in a back-to-back Schottky diode state. In this state, the hysteresis loop of the output curve means IP polarization and Schottky barrier controlled by V_{d}. When a negative programming voltage higher than the coercive voltage is applied to V_{d}, the IP polarization is aligned in a form facing the right side. The polarization direction aligned like this forms a higher and wider barrier, and induces a lower current state as a result. On the contrary, a positive programming voltage induces a high current state. FIG. 24 is a mimetic view showing the OOP polarization control and IP polarization control described above. The OOP (V_{g}) programming voltage may adjust channel conductance by controlling carrier density of the channel, and the IP (V_{d}) programming voltage may control the current level by adjusting carrier injection through control of band alignment between channels/electrodes. Additionally, the output curve of the D-FeFET programmed with only V_{g} or only V_{d} can be confirmed in FIGS. 22 and 23. When it is programmed with only V_{g} without V_{d} programming voltage, the on/off ratio of the channel current appears to be about 10⁴. When it is programmed with only V_{d} without V_{g} programming voltage, the on/off ratio of the channel current appears to be about 10². The difference in the characteristic of controlling current (or resistance) according to the type of programming voltage (V_{d}, V_{g}) is the driving force that can implement the four stably distinguished current (resistance) states shown in FIG. 5.

### <Operation of SnS FeFET device without CIPS>

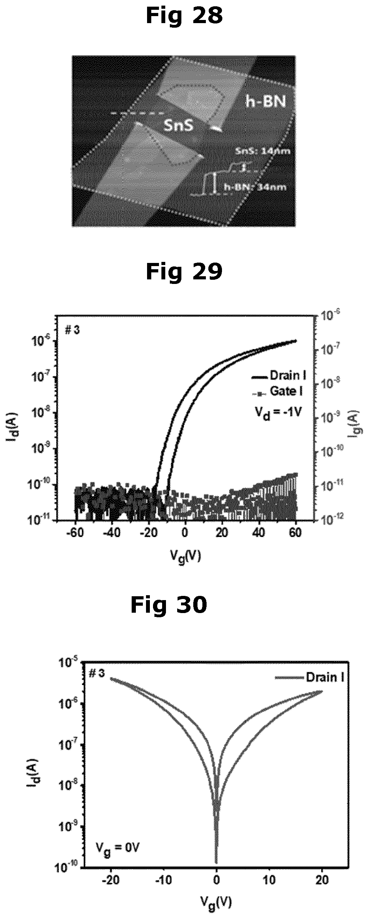

FIGS. 27 to 30 show an FeFET device of a h-BN/SnS structure without CIPS. FIGS. 27 and 28 show a mimetic view (FIG. 27) and an OM image (FIG. 28) of a h-BN/SnS device structure without CIPS. FIGS. 29 and 30 show the transfer curve (FIG. 29) and the output curve (FIG. 30) of the h-BN/SnS FeFET. It can be confirmed through FIG. 29 that the OOP polarization direction and wide hysteresis cannot be controlled with the gate voltage since there is no CIPS. On the contrary, it can be confirmed in FIG. 30 that hysteresis is implemented through control of IP polarization of SnS by the drain voltage.

### <Transition between current (resistance) states>

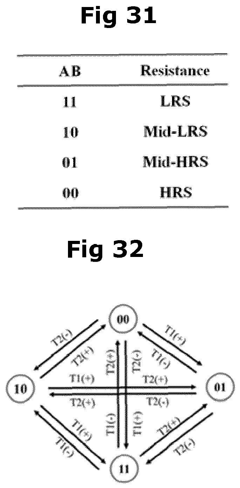

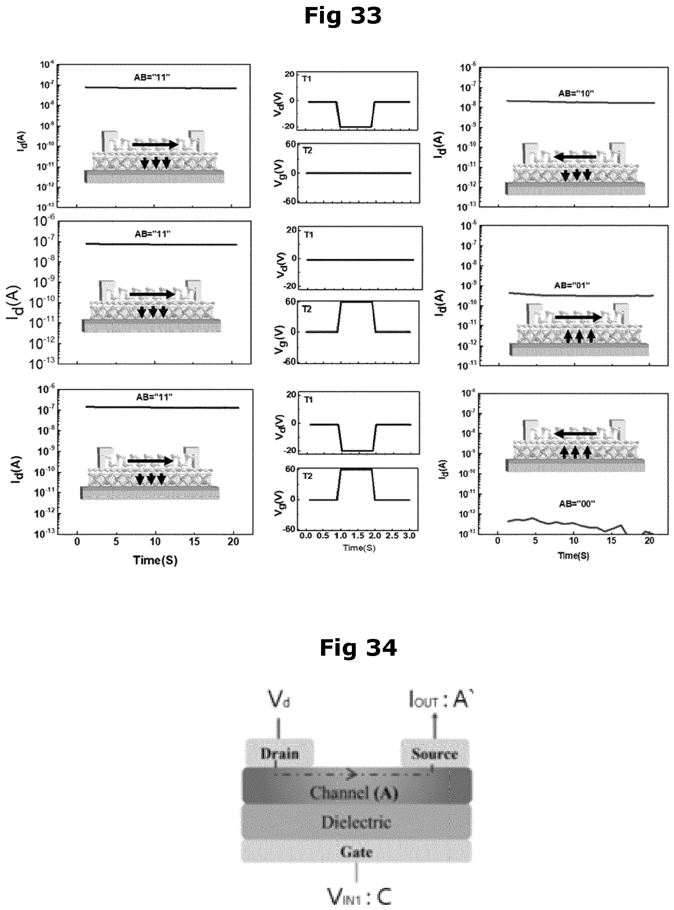

FIGS. 31 to 33 show state transition of the device resistance state implemented according to an input value. The OOP electric field controls carrier density through control of the OOP polarization direction, and the IP polarization may be controlled only by the IP electric field. Therefore, in the present invention, OOP and IP polarization can be independently controlled through the OOP voltage V_{g} and the IP voltage V_{d}, respectively. As a result, the four current (resistance) states may be immediately transited from one current state to the other three current states without an intermediate state. In the case of an existing multi-state FeFET, the multi-state is implemented by utilizing the intermediate polarization state between two saturated polarization states, and in order to utilize this, additional energy and time need to be consumed as it should go through several other intermediate states to reach a targeted intermediate state. FIG. 31 shows a digital configuration that can be implemented in correspondence to the four resistance states, in which the resistance state of the D-FeFET is named as AB. HRS, MiD-HRS, MiD-LRS, and LRS are expressed to correspond to "00", "01", "10", and "11", respectively. FIG. 32 is a mimetic view showing input conditions needed for transition between four resistance states. For example, when it is desired to transit the resistance state from "11" to "10", a negative programming voltage only needs to be applied to T1. When it is desired to transit from "11" to "01", a positive programming voltage only needs to be applied to T2. When it is desired to transit from "11" to "00", a negative programming voltage needs to be applied to T1, and a positive programming voltage needs to be applied to T2, simultaneously. FIG. 33 is a result experimentally showing the transition between resistance states. When the resistance state is read at V_{d} lower than the programming voltage, after going through the process of applying the programming voltage pulse marked as Process, starting from the initial resistance state marked as Initialization, it can be confirmed that the transited resistance state is stored in the D-FeFET. The characteristics of transition from one resistance state to another resistance state are shown in FIG. 33 on the basis of FIG. 32.

### <Measurement of logic-in-memory computing characteristics>

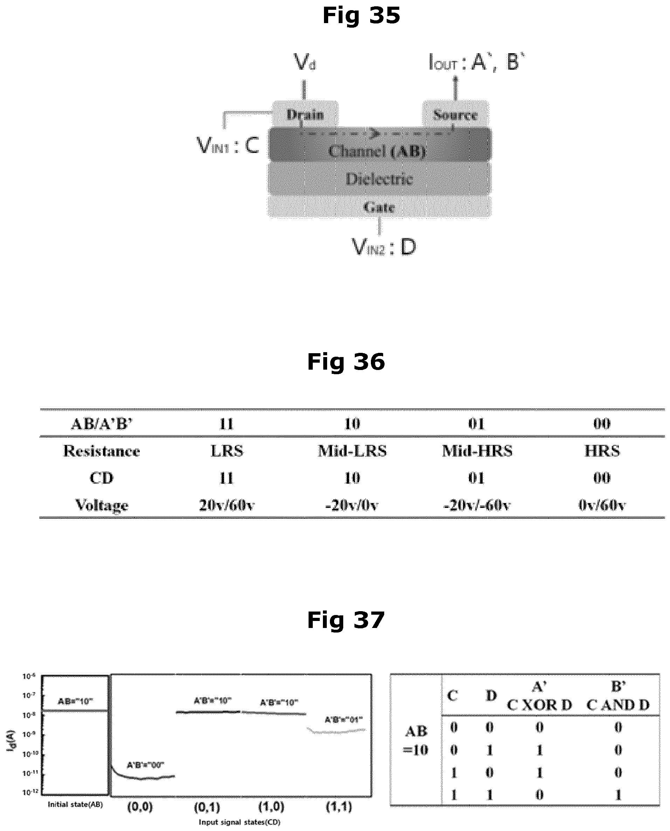

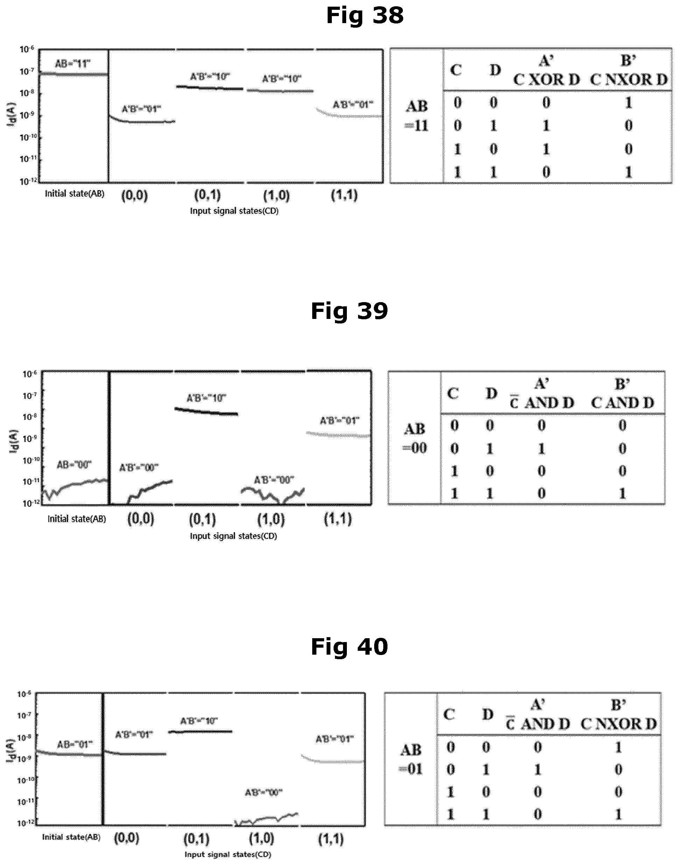

FIGS. 34 to 37 show measurement of logic-in-memory (LiM) characteristics of a 2D D-FeFET device. All existing 2D FeFET-based LiM computing devices are based on 1-bit memory, and 2-bit memorybased LIM computing has not been studied. FIG. 34 shows a method of performing an LiM computing function in a general 1-bit FeFET. 1-bit digital information is expressed as A (initial state), an input voltage pulse applied to the gate terminal for logic operation is expressed as C, and a finally implemented resistance state (resistance state measured while application of the input pulse is stopped) or an output value is indicated as A'. FIG. 39 shows a method of performing the LiM computing function in the 2-bit D-FeFET implemented in the present invention. The initial storage value is expressed as AB, the input signal (voltage pulse) applied to the source T1 and gate T2 terminals for implementation of a logic operation is expressed as CD, and the finally implemented logic state is expressed as output values A' and B'. At this point, C corresponds to T1 (V_{d}), and D corresponds to T2 (V_{g}). FIG. 36 shows a table digitizing each resistance state and input voltage value. AB denotes the initial resistance state, A'B' denotes the resistance state after an input value, and CD denotes an input value (C is the drain voltage input, and D is the gate voltage input). In order to implement the transition between the resistance states shown in FIG. 32, voltage conditions are set according to the digital signal configuration of input signal CD as shown in FIG. 36. The voltage conditions are set such that "20V/60V" as "11", "-20V/0V" as "10", "-20V/-60V" as "01", and "0V/60V" as "00". FIG. 37 shows an experimental proof of the output value (A'B') according to the input value CD when the initial storage value AB is "10" (FIG. 37) and a logic table corresponding thereto. At this point, a logic-in-memory function that implements the XOR operation and AND logic function in parallel within one operation is implemented by performing logic operation A' = C XOR D and logic operation B' = C AND D.

### <Measurement of reconfigurable logic-in-memory computing characteristics>

FIGS. 38 to 40 show reconfigurable logic-in-memory computing characteristics that perform different logical operations according to the initial storage value. FIGS. 38, 39, and 40 show the A'B' value transited according to the input value CD when the initial storage value AB = "11", "00", and "01", respectively. As shown in the logic table, it can be seen that the logic function performed at A'B' is transited as the initial storage value AB is reconstructed.

### <Tables summarizing reconfigurable logic-in-memory computing characteristics>

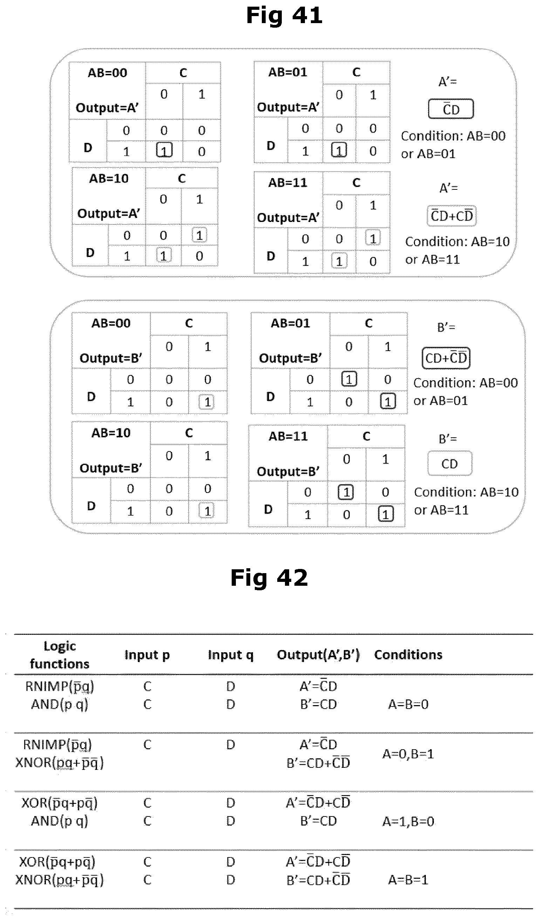

FIG. 41 shows a Karnaugh Map of logical operations for the output values A' and B' according to the initial storage value AB and input C and D. FIG. 42 shows a table summarizing the logical operation functions that can be implemented according to A, B, C, and D generated on the basis of FIG. 41.

The junction structure element according to an embodiment of the present invention has a characteristic of independently controlling polarization in different directions, and may implement a 2-bit memory.

The method of manufacturing a junction structure element according to an embodiment of the present invention may manufacture a junction structure element having the characteristics described above.

The in-memory computing device according to an embodiment of the present invention is capable of direct transition between states using the junction structure element, and may perform in-memory computing having functional completeness as a NAND can be implemented.

Although the present invention has been described above with reference to preferred embodiments, it could be understood that those skilled in the art may make various modifications and changes to the present invention without departing from the spirit and scope of the present invention disclosed in the patent claims below.

### DESCRIPTION OF SYMBOLS

100: Junction structure element
101: First polarization layer
102: Second polarization layer
103: Insulating layer
104: Source electrode
105: Drain electrode
106: Gate electrode
200: Method of manufacturing junction structure element

## Claims

1. A junction structure element comprising polarization layers, a source electrode, a drain electrode and a gate electrode,
Wherein the junction structure element comprises:
a first polarization layer containing a material having a ferroelectric characteristic of being polarized only horizontally;
a second polarization layer disposed on the first polarization layer and containing a material having a ferroelectric characteristic of being polarized only vertically;
a source electrode and a drain electrode each in contact with the first polarization layer and spaced apart from each other; and
a gate electrode disposed on the second polarization layer.

2. The junction structure element according to claim 1, further comprising an insulating layer disposed between the first polarization layer and the second polarization layer and containing a material having non-dielectric and insulating characteristics.

3. The junction structure element according to claim 2, wherein thickness of the insulating layer is 5 to 15nm.

4. The junction structure element according to claim 2 or 3, wherein the insulating layer contains h-BN.

5. The junction structure element according to any one of claims 1 to 4, wherein the first polarization layer and the second polarization layer contain one or more materials independently and differently selected from a group including CuInP₂S₆ (CIPS) and SnS.

6. The junction structure element according to claim 5, wherein the first polarization layer contains SnS, and the second polarization layer contains CIPS.

7. The junction structure element according to any one of claims 1 to 6, wherein when a voltage equal to or higher than a predetermined first threshold voltage is applied between the source electrode and the drain electrode, the first polarization layer is polarized in a horizontal direction, or a polarization state is released, and when a voltage is applied to the gate electrode, the second polarization layer is polarized in a vertical direction, or the polarization state is released, and whether the first polarization layer is polarized and whether the second polarization layer is polarized independently determine electrical conductivity of the first polarization layer.

8. The junction structure element according to claim 7, wherein when the first polarization layer and the second polarization layer are polarized in the horizontal and vertical directions, respectively, the polarization layers are polarized to be saturated.

9. The junction structure element according to claim 7 or 8, wherein the junction structure element may have a first resistance state; a fourth resistance state having an electrical conductivity higher than that of the first resistance state; a second resistance state having an electrical conductivity between the first resistance state and the fourth resistance state; and a third resistance state having an electrical conductivity between the second resistance state and the fourth resistance state, wherein the first resistance state is implemented by applying a positive voltage between the source electrode and the drain electrode and a negative voltage to the gate electrode, the second resistance state is implemented by applying a negative voltage between the source electrode and the drain electrode and a negative voltage to the gate electrode, the third resistance state is implemented by applying a positive voltage between the source electrode and the drain electrode and a positive voltage to the gate electrode, and the fourth resistance state is implemented by applying a negative voltage between the source electrode and the drain electrode and a positive voltage to the gate electrode.

10. The junction structure element according to any one of claims 1 to 9, wherein thickness of the first polarization layer is 5 to 15nm, and thickness of the second polarization layer is 60 to 100nm.

11. The junction structure element according to any one of claims 1 to 10, wherein each of the source electrode and the drain electrode contains one or more materials selected from a group including titanium (Ti) and gold (Au), and the gate electrode contains Si/SiO₂.

12. A junction structure element comprising polarization layers, a source electrode, a drain electrode and a gate electrode,
Wherein the junction structure element comprises:
a first polarization layer containing a material having a ferroelectric characteristic of being polarized only horizontally;
a second polarization layer disposed on the first polarization layer 101 and containing a material having a ferroelectric characteristic of being polarized only vertically;
a source electrode and a drain electrode each in contact with the first polarization layer and spaced apart from each other; and
a gate electrode disposed on the second polarization layer, wherein
as each of the first polarization layer and the second polarization layer may independently have polarization directions of two states including a direction from an anode to a cathode or a direction from the cathode to the anode, there may be a total of four states.

13. A method of manufacturing a junction structure element comprising multiple steps for forming thin films and electrodes,
Wherein the method of manufacturing a junction structure element comprises:
a first step of forming, using a physical peeling method, a first thin film containing a ferroelectric material having a horizontal polarization characteristic, a second thin film containing a ferroelectric material having a vertical polarization characteristic, and an insulating thin film having an insulating characteristic; and
a second step of forming the insulating thin film between the first thin film and the second thin film, forming source and drain electrodes respectively in contact with the first thin film and spaced apart from each other, and forming a gate electrode in contact with the second thin film.

14. The method according to claim 13, wherein the second step is performed by sequentially transferring the second thin film, the insulating thin film, and the first thin film on a substrate containing Si/SiO₂, and the gate electrode is implemented by the substrate.

15. The method according to claim 14, wherein the first thin film and the second thin film are formed as a thin film containing one or more materials independently and differently selected from a group including CuInP₂S₆ (CIPS) and SnS.

16. The method according to claim 15, wherein the first thin film is formed to contain SnS, the second thin film is formed to contain CIPS, and the insulating thin film is formed to contain h-BN.

17. The method according to claim 16, wherein the first thin film is formed to have a thickness of 5 to 15nm, the second thin film is formed to have a thickness of 60 to 100nm, and the insulating layer is formed to have a thickness of 5 to 15nm.

18. An in-memory-computing device comprising a junction structure element according to any one of claims 1 to 12, wherein the junction structure element may have a first resistance state; a fourth resistance state having an electrical conductivity higher than that of the first resistance state; a second resistance state having an electrical conductivity between the first resistance state and the fourth resistance state; and a third resistance state having an electrical conductivity between the second resistance state and the fourth resistance state, and direct transition between the first to fourth resistance states is possible.

19. The device according to claim 18, having functional completeness.
